# FASCICULE DE BREVET EUROPEEN

(11) **EP 2 527 848 B1**
(45) Date de publication et mention de la délivrance du brevet: **26.03.2014**
(21) Numéro de dépôt: 12290173.9
(22) Date de dépôt: 25.05.2012
(51) Int. Cl.: G01R 15/18

(54) **Dispositif de montage d'au moins un conducteur de courant électrique dans un capteur de courant électrique et capteur de courant équipé d'un tel dispositif de montage**
Vorrichtung zur Montage mindestens eines Stromleiters in einem Stromabnehmer, und mit einer solchen Montagevorrichtung ausgestatteter Stromabnehmer
Device for mounting at least one electric current conductor in an electric current sensor and current sensor equipped with such a mounting device

(30) Priorité: 26.05.2011 FR 1154602
(43) Date de publication de la demande: 28.11.2012
(73) Titulaire: Socomec S.A., 67230 Benfeld (FR)
(72) Inventeur: Morel, Jean-Philippe, 67230 Benfeld (FR); Reinbolt, Eric, 67600 Hilsenheim (FR)
(74) Mandataire: Koelbel, Caroline

(56) Documents cités:
- FR-A1- 2 507 811
- FR-A1- 2 858 058
- FR-A1- 2 881 276

## Description

### Domaine technique:

La présente invention concerne un dispositif de montage d'au moins un conducteur de courant électrique, tel que notamment un câble électrique, un faisceau de câbles électriques, une barre conductrice ou similaire, dans un capteur de courant électrique, ledit dispositif comportant un manchon pourvu d'un passage traversant s'étendant entre un orifice d'entrée et un orifice de sortie le long d'un axe de symétrie dudit manchon.

La présente invention concerne également un capteur de courant électrique comportant une ouverture centrale agencée pour être traversée par au moins un conducteur de courant électrique et un dispositif de montage monté dans ladite ouverture centrale pour centrer automatiquement ledit au moins un conducteur de courant électrique dans ledit capteur de courant, ledit dispositif de montage comportant un manchon pourvu d'un passage traversant pour recevoir ledit au moins un conducteur de courant électrique et s'étendant entre un orifice d'entrée et un orifice de sortie le long d'un axe de symétrie dudit manchon.

### Technique antérieure :

Dans le domaine de la distribution électrique de puissance, qui utilise une large gamme de conducteurs de courant électrique, aussi bien en dimension de section qu'en forme de section afin de pouvoir répondre à une large gamme de puissance, il n'existe à l'heure actuelle aucun dispositif spécifique pour monter et centrer un conducteur de courant électrique, tel que notamment un câble électrique, un faisceau de câbles électriques, une barre conductrice ou similaire, dans l'ouverture centrale d'un capteur de courant électrique.

Or, afin de garantir la qualité des valeurs mesurées du courant électrique, il est absolument indispensable que le conducteur de courant électrique soit parfaitement centré par rapport à la bobine et par extension dans l'ouverture centrale du capteur de courant électrique. En effet, lorsque le conducteur de courant électrique est excentré par rapport au capteur de courant électrique, un phénomène de saturation locale du noyau magnétique, engendrant une mesure de courant électrique faussée, peut survenir. La manière de procéder actuelle, consistant à enfiler le conducteur de courant électrique dans ladite ouverture puis à utiliser des cales en carton ou autre, et/ou des colliers de serrage pour réaliser son centrage, est non seulement laborieuse mais ne permet en outre pas toujours de garantir ledit centrage et donc la justesse des mesures relevées permettant d'atteindre le niveau de qualité requis. Elle n'est par conséquent pas satisfaisante.

D'autre part, certains capteurs de courant électrique nécessitent d'être fixés sur un support tel que sur un châssis d'armoire électrique. A défaut d'une autre possibilité, un aménagement spécifique, tel que par exemple un rail ou une platine, disposé au cas par cas à proximité du capteur de courant électrique concerné, doit parfois être réalisé à l'intérieur de l'armoire électrique. Une telle installation suppose par conséquent des étapes supplémentaires qui ont pour inconvénient de prolonger le temps de travail des opérateurs.

La publication FR 2 858 058 A1 concerne un capteur de courant mesurant le courant circulant dans un câble électrique raccordé à une batterie d'un véhicule. Il comporte à cet effet un manchon de centrage entourant ledit câble et introduit dans l'ouverture centrale du capteur de courant auquel il est fixé par un système à baïonnette. Ce manchon de centrage n'est donc pas prévu pour être autoporté, ni pour s'adapter à différents diamètres de câbles.

### Exposé de l'invention :

La présente invention vise à pallier ces inconvénients en proposant un dispositif de montage d'au moins un conducteur de courant électrique dans l'ouverture centrale d'un capteur de courant électrique, un même dispositif pouvant convenir à différentes sections de conducteur afin de couvrir une large gamme de courants, dont la mise en oeuvre permet d'obtenir simultanément le centrage du conducteur de courant électrique dans ladite ouverture, son maintien et son arrêt en translation axiale sur ledit capteur de courant sans organe de liaison complémentaire, et dans certains cas, la fixation du capteur de courant électrique sur ledit conducteur de courant électrique. Un tel dispositif de montage permet par conséquent de s'affranchir des techniques utilisées actuellement, relevant de l'improvisation et du domaine du bricolage, tout en garantissant la fiabilité, la précision et la qualité des mesures effectuées pour une large de gamme de courants.

Dans ce but, l'invention concerne un dispositif de montage du genre indiqué en préambule, **caractérisé en ce que** ledit manchon est réalisé en un matériau élastique et comporte deux lèvres souples s'étendant radialement autour de sa périphérie extérieure, respectivement de part et d'autre d'une zone intermédiaire, lesdites lèvres souples étant agencées pour adopter une position de montage dans laquelle elles sont déformées et repliées en direction dudit manchon et une position de repos dans laquelle elles sont déployées.

Selon une variante de réalisation préférentielle, la section externe de ladite zone intermédiaire dudit manchon et/ou ladite section desdits orifices d'entrée et de sortie dudit passage traversant sont de forme circulaire ou polygonale.

Selon une caractéristique additionnelle du dispositif de montage selon l'invention, ledit manchon comporte deux zones d'extrémités s'étendant respectivement entre ladite zone intermédiaire et l'un desdits orifices d'entrée ou de sortie dudit passage traversant, et au niveau desquelles ledit passage traversant comporte des dimensions décroissantes de la zone intermédiaire dudit manchon en direction de chacun des orifices d'entrée ou de sortie dudit passage traversant.

Dans ce cas, conformément à une variante de réalisation, ledit passage traversant peut présenter une forme tronconique au niveau de chacune desdites deux zones d'extrémité.

Une autre caractéristique de l'invention est encore définie par le fait que la face externe de chacune desdites deux zones d'extrémité comporte une pluralité de gorges annulaires s'étendant autour de leur périphérie délimitant une pluralité d'éléments sécables.

Avantageusement, le dispositif de montage selon l'invention se caractérise également en ce que ladite zone intermédiaire dudit manchon comporte sur sa périphérie extérieure, autour de chacune de ses extrémités, un évidement annulaire agencé pour permettre le repliement de ladite lèvre souple correspondante en direction dudit manchon.

D'autre part, selon le cas, lesdites lèvres souples peuvent être continues et comporter chacune une collerette s'étendant autour de la périphérie extérieure dudit manchon, ou discontinues et comporter chacune au moins deux pattes ou deux languettes s'étendant autour de la périphérie extérieure dudit manchon.

Selon une variante de réalisation préférentielle de l'invention, ledit manchon comporte deux demi-coques disposées l'une contre l'autre par rapport à un plan de symétrie passant par l'axe de symétrie dudit manchon, lesdites demi-coques étant reliées entre elles par des moyens d'assemblage qui peuvent être réversibles.

Dans ce cas, lesdits moyens d'assemblage peuvent comporter une charnière reliant les deux demi-coques entre elles de manière telle qu'elles peuvent pivoter l'une par rapport à l'autre entre une position ouverte dudit manchon dans laquelle un accès audit passage traversant est offert et une position fermée dudit manchon et inversement. Ils peuvent en outre comporter des moyens de verrouillage dudit manchon en position fermée.

Avantageusement, lesdits moyens de verrouillage comportent au moins un clip de verrouillage relié à l'une desdites demi-coques et agencé pour coopérer avec au moins un autre clip de verrouillage de forme complémentaire que comporte l'autre desdites demi-coques.

D'autre part, la présente invention prévoit encore que le matériau élastique dudit manchon est choisi parmi un plastique thermoplastique ou un plastique thermodurcissable souple, le silicone, le caoutchouc naturel ou synthétique.

Dans ce but également l'invention concerne un capteur de courant tel que défini en préambule, **caractérisé en ce que** ledit manchon est réalisé en un matériau élastique et comporte deux lèvres souples s'étendant radialement autour de sa périphérie extérieure, respectivement de part et d'autre d'une zone intermédiaire, montée dans ladite ouverture centrale, lesdites lèvres souples étant agencées pour adopter une position de montage dans laquelle elles sont déformées et repliées en direction dudit manchon permettant l'introduction dudit manchon dans ladite ouverture centrale et une position de repos dans laquelle elles sont déployées pour reposer autour de ladite ouverture centrale respectivement sur chacune des deux faces opposées dudit capteur de courant électrique.

De manière préférentielle, le matériau élastique dont est constitué ledit manchon présente une épaisseur suffisante lui conférant une rigidité permettant audit manchon de supporter à lui seul le poids dudit capteur de courant électrique, indépendamment de tout autre moyen de soutien dudit capteur de courant électrique.

### Description sommaire des dessins:

La présente invention et ses avantages apparaîtront mieux dans la description suivante d'un mode de réalisation donné à titre d'exemple non limitatif, en référence aux dessins annexés, dans lesquels:
- les figures 1 et 2 représentent des vues en perspective d'un manchon faisant partie du dispositif de montage selon l'invention, montrant respectivement la charnière et les clips de fixation reliant les deux demi-coques dudit manchon,
- la figure 3 est une vue du manchon de la figure 1 dans la position ouverte des deux demi-coques, et dans lequel un conducteur électrique comportant un faisceau de deux câbles électriques est disposé dans ledit passage traversant,
- les figures 4 et 5 sont des vues du manchon de la figure 1, dans la position fermée des deux demi-coques autour desdits câbles électriques, respectivement avant et après son montage dans un capteur de courant électrique, et
- les figures 6 et 7 sont des vues en coupe du manchon de la figure 1, respectivement pendant et après son montage dans un capteur de courant électrique.

### Illustration de l'invention et meilleure manière de la réaliser:

En référence aux figures, la présente invention a trait à un dispositif de montage 1 d'un conducteur de courant électrique 2, tel que par exemple un faisceau de deux câbles de section circulaire, à l'intérieur d'un capteur de courant électrique 3.

Conformément à l'invention, le dispositif de montage 1 est conformé de manière telle qu'une fois monté dans l'ouverture centrale 4 du capteur de courant électrique 3, de section circulaire dans l'exemple illustré, il est auto-maintenu radialement et axialement, et le conducteur de courant électrique 2 est automatiquement centré dans ladite ouverture centrale 4. Un tel dispositif de montage 1 permet par conséquent de garantir la qualité des mesures de courant électrique relevées tout en évitant l'emploi de cales, colliers de serrage ou autres moyens de centrage improvisés, classiquement mis en oeuvre. Bien entendu, bien que dans l'exemple illustré, le dispositif de montage 1 est agencé pour permettre le centrage d'un conducteur de courant électrique 2 de section circulaire dans un capteur de courant électrique 3 comportant une ouverture centrale 4 de section circulaire, l'invention s'étend également à d'autres variantes de réalisation du dispositif de montage 1, conformées de manière à être adaptées aux natures et formes respectives du conducteur électrique 2 et du capteur de courant électrique 3, comme expliqué plus en détail ci-après.

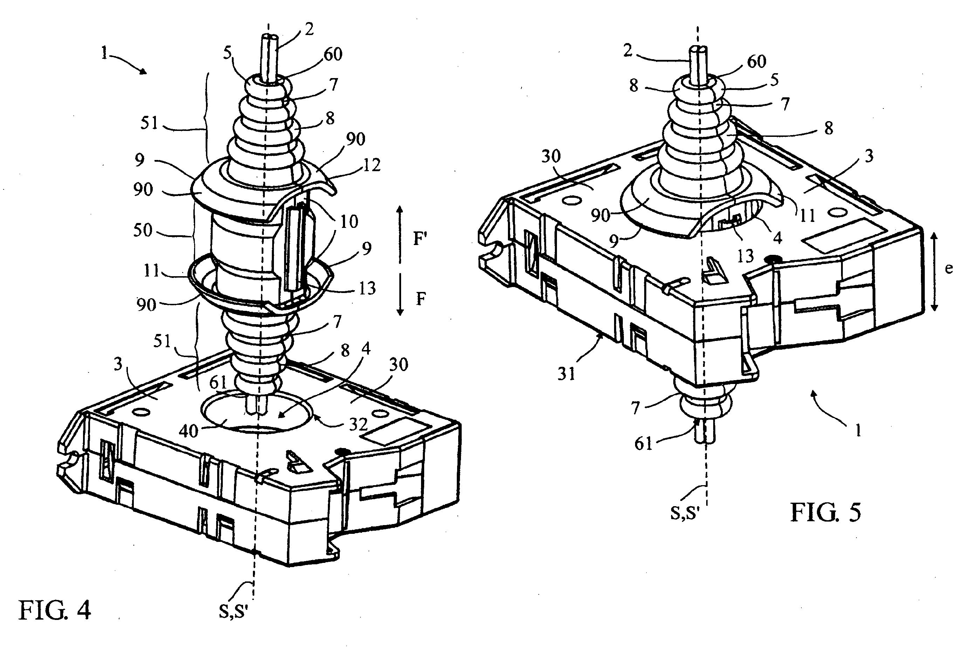

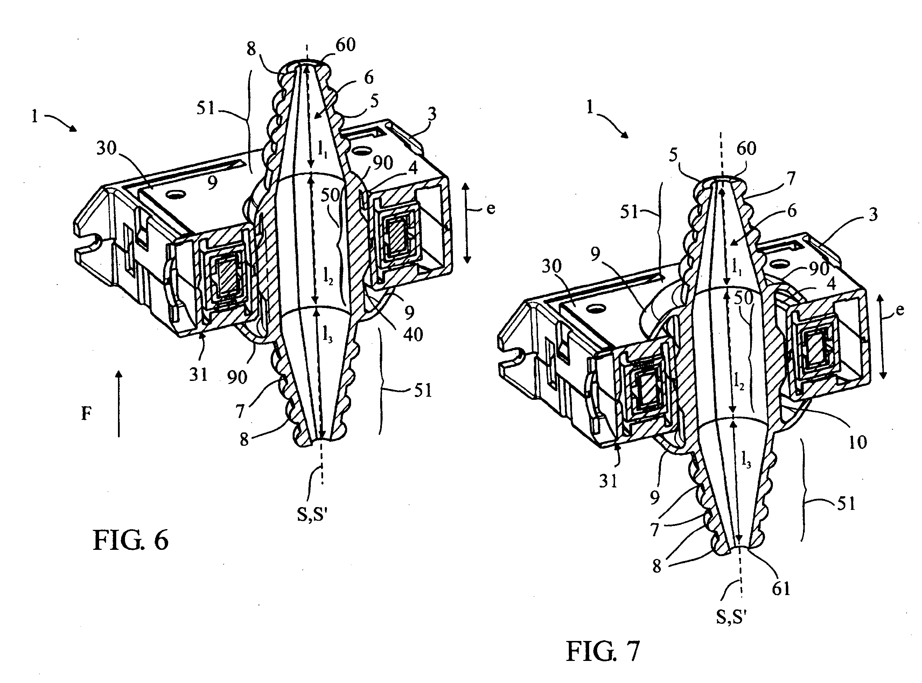

Dans l'exemple illustré, le dispositif de montage 1 comporte un manchon 5 électriquement isolant et réalisé en un matériau élastique, tel que notamment du silicone, du caoutchouc naturel ou synthétique, ou tout autre matériau choisi parmi un plastique thermoplastique ou un plastique thermodurcissable souple. Il comporte un passage traversant 6, apte à recevoir le conducteur de courant électrique 2 s'étendant le long de son axe de symétrie S et délimité par un orifice d'entrée 60 et un orifice de sortie 61. Tel que visible sur les figures, le manchon 5 présente deux zones d'extrémités 51 comportant chacune l'un desdits orifices d'entrée ou de sortie 60, 61 et réunies par une zone intermédiaire 50. Les zones d'extrémités 51 et la zone intermédiaire 50 présentent des longueurs I₁, I₂, I₃ (cf. fig. 6, 7) telles que lorsque le manchon 5 est monté dans le capteur de courant électrique 3, la zone intermédiaire 50 s'étend à l'intérieur de l'ouverture centrale 4 du capteur de courant électrique 3, tandis que les orifices d'entrée 60 et de sortie 61 du passage traversant 6 débouchent chacune respectivement au niveau de deux faces opposées 30, 31 dudit capteur de courant électrique 3 (cf. fig. 5-7). Selon le cas, les longueurs I₁ et I₃ peuvent être identiques comme dans l'exemple illustré ou différentes, tandis que la longueur I₂ est adaptée à l'épaisseur du capteur de courant électrique 3 considéré.

Avantageusement, les orifices d'entrée et de sortie 60, 61 comportent une section circulaire de forme complémentaire à celle du conducteur de courant électrique 2, de sorte qu'une fois engagé dans le passage traversant 6, le conducteur de courant électrique 2 est fermement enserré par le manchon 5 au niveau de chacun desdits orifices d'entrée et de sortie 60, 61, et demeure par conséquent bloqué en position par rapport au manchon 5. Bien entendu, la section des orifices d'entrée ou de sortie peut être de forme différente, par exemple carrée ou rectangulaire, ou toute autre forme adaptée à celle du conducteur de courant électrique 2 concerné. Par ailleurs, la zone intermédiaire 50 présente une section externe de forme complémentaire à celle de l'ouverture centrale 4 du capteur de courant électrique 3 de sorte que lorsqu'elle est disposée à l'intérieur de ladite ouverture centrale 4, une fois le manchon 5 monté dans ledit capteur de courant électrique 3, elle s'y trouve emboîtée (cf. fig. 5), et l'axe de symétrie S dudit manchon se confond avec l'axe de symétrie S' du capteur de courant électrique 3, le passage traversant 6 étant alors parfaitement centré dans l'ouverture centrale 4 de ce dernier. Bien qu'étant de forme circulaire dans l'exemple illustré, la section externe de ladite zone intermédiaire 50 peut également être polygonale, par exemple carrée ou rectangulaire, en vue de permettre un emboîtement du manchon 5 dans une ouverture centrale 4 présentant une telle section polygonale, par exemple carrée ou rectangulaire.

En référence aux figures 6 et 7, le passage traversant 6 comporte, dans l'exemple illustré, une forme tronconique au niveau de chacune desdites deux zones d'extrémité 51, et présente des diamètres décroissants de la zone intermédiaire 50 du manchon 5 en direction de chacun des orifices d'entrée ou de sortie 60, 61. Une telle configuration permet ainsi une utilisation du même manchon 5 pour une gamme de conducteurs de courant électrique 2 dont les diamètres sont compris dans un intervalle de valeurs s'étendant entre le plus petit et le plus grand des diamètres du passage traversant 6, permettant de couvrir une large gamme de courants. Ainsi, chacune des zones d'extrémités 51 peut être raccourcie par un opérateur qui en sectionne le bout, de sorte à obtenir un orifice d'entrée et de sortie 60, 61 de dimension supérieure, adaptée à celle du conducteur de courant électrique 2 concerné. Une telle opération peut être répétée plusieurs fois jusqu'à atteindre la zone intermédiaire 50, au niveau de laquelle le diamètre des orifices d'entrée et de sortie 60, 61 atteint la valeur la plus élevée prévue.

Selon une caractéristique avantageuse de l'invention, la face externe de chacune desdites deux zones d'extrémité 51 peut comporter, en vue de faciliter l'adaptation du manchon 5 aux dimensions du conducteur de courant électrique 2 concerné, une pluralité de repères de coupe représentatifs du diamètre du passage traversant 6. Ces repères de coupe peuvent par exemple être définis par une pluralité de gorges annulaires 7 s'étendant autour de la périphérie desdites zones d'extrémité 51 et délimitant, le cas échéant, une pluralité d'éléments sécables 8. Les gorges annulaires 7 peuvent, par ailleurs, avoir une fonction supplémentaire qui sera décrite plus loin.

Selon une autre caractéristique de l'invention, la longueur I₂ de la zone intermédiaire 50 du manchon 5 est sensiblement équivalente à celle de l'ouverture centrale 4 du capteur de courant électrique 3 tandis que le manchon 5 comporte deux lèvres souples, définies dans l'exemple illustrée par deux collerettes continues 9 s'étendant radialement autour de sa périphérie extérieure, respectivement de part et d'autre de la zone intermédiaire 50.

En référence aux figures 6 et 7, les collerettes 9 sont agencées pour adopter une position dans laquelle au moins l'une d'entre elles est déformée et repliée en direction de la zone intermédiaire 50 du manchon 5 (fig. 6), pour permettre l'introduction de celui-ci dans l'ouverture centrale 4 du capteur de courant électrique 3 et une autre position dans laquelle elles sont déployées et reposent respectivement, lorsque le manchon 5 est disposé à l'intérieur de l'ouverture centrale 4, sur une zone 32 (cf. fig. 4) bordant ladite ouverture centrale 4 sur chacune des deux faces opposées 30, 31 du capteur de courant électrique 3.

La position repliée est provoquée par la pression exercée sur la face externe 90 d'une collerette 9, d'abord par ladite zone 32 d'une face 30 ou 31, puis par la paroi périphérique 40 de l'ouverture centrale 4, lorsque le manchon 5 est progressivement engagé dans l'ouverture centrale 4 pour y être monté en introduisant une de ses zones d'extrémité 51 depuis ladite face 30 ou 31 dans le sens de la flèche F (cf. fig. 4 et 6). La position déployée correspond à la position au repos de la collerette 9, dans laquelle elle retourne automatiquement après avoir entièrement traversée l'ouverture centrale 4 du capteur de courant électrique 3, et qu'elle n'est plus soumise à la pression de la paroi 40 et émerge sur la face opposée 31 ou 30.

Selon une autre variante de réalisation non illustrée, les lèvres souples pourraient également être discontinues et définies, par exemple, par une pluralité de pattes ou languettes régulièrement réparties autour de la périphérie extérieure du manchon 5.

Tel que visible sur les figures, la zone intermédiaire 50 porte en outre un évidement annulaire 10 sur sa périphérie extérieure, autour de chacune de ses extrémités, pour permettre le repliement de la collerette 9 en direction du manchon 5 en phase de montage comme expliqué précédemment.

Grâce à une telle configuration, lorsque le manchon 5 est emboîté dans l'ouverture centrale 4, le capteur de courant électrique 3 est pris en sandwich entre les deux collerettes 9 et est donc avantageusement supporté à la fois par le conducteur de courant électrique 2 et le manchon 5 dont le matériau élastique constitutif présente une épaisseur appropriée à cet effet. Ceci permet, dans certains cas, de s'affranchir d'une fixation supplémentaire du capteur de courant électrique 3 sur un rail, une armoire électrique ou similaire. De même, le manchon 5 est auto-maintenu et bloqué en translation axiale dans le capteur de courant électrique 3 grâce aux deux collerettes 9, sans aucun organe de liaison complémentaire.

Bien entendu, le manchon 5 peut être retiré de l'ouverture centrale 4 du capteur de courant électrique 3 par simple traction dans un sens ou dans l'autre (ici le sens de la flèche F', inverse de celui de la flèche F). L'une des deux collerettes 9 est alors déformée vers une position escamotée dans laquelle elle est repliée en direction d'une zone d'extrémité 51 du manchon 5 jusqu'au retrait complet de celui-ci. Après retrait du conducteur de courant électrique 2 du passage traversant 6, un tel manchon 5 peut, le cas échéant, avantageusement être réutilisé.

Le manchon 5 peut être réalisé d'une seule pièce fermée, auquel cas le capteur de courant électrique 2 doit être enfilé dans le passage traversant 6 depuis l'orifice d'entrée 60 vers l'orifice de sortie 61. Il peut également être réalisé d'une seule pièce ouvrante, comme dans la variante de réalisation illustrée aux différentes figures, dans lesquelles il comporte deux demi-coques 11, 12 disposées l'une contre l'autre par rapport à un plan de symétrie du manchon 5, passant par l'axe de symétrie S et par les zones de jonction des deux demi-coques 11, 12. Les deux demi-coques 11, 12 sont assemblées entre elles d'un côté par un film charnière 13 faisant partie intégrante de la pièce et de l'autre côté par deux clips de verrouillage réversibles 14, 15 de forme complémentaire, respectivement reliés à chacune des deux demi-coques 11, 12. Ces clips de verrouillage peuvent être supprimés ou remplacés par tout autre moyen de verrouillage équivalent et réversible. Le manchon 5 peut également être réalisé en plusieurs pièces, par exemple en deux demi-coques 11, 12 indépendantes et assemblées entre elles par tout moyen de verrouillage adéquat.

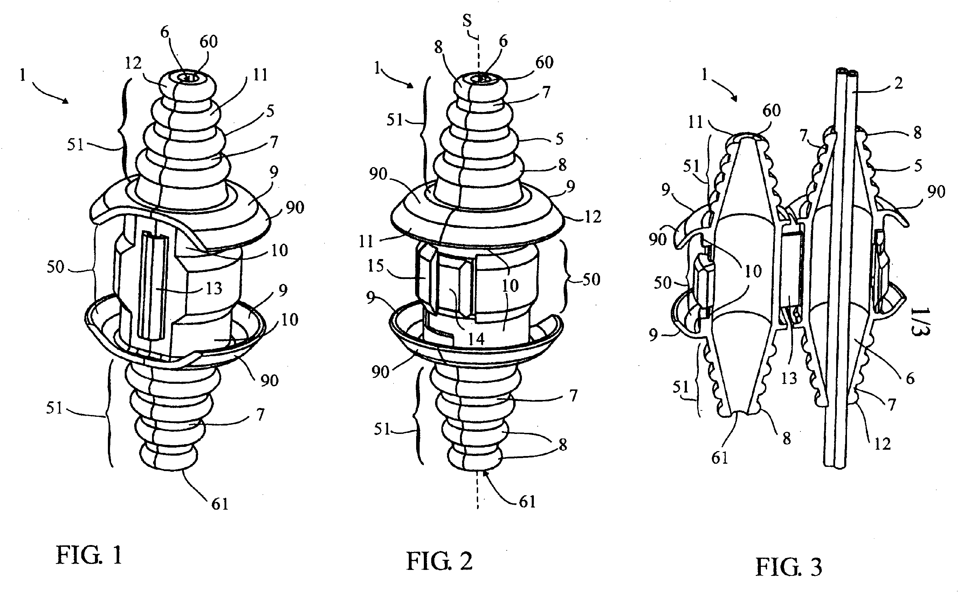

La configuration telle qu'illustrée permet avantageusement un pivotement des deux demi-coques 11, 12 l'une par rapport à l'autre autour de la charnière 13 entre une position fermée (cf. fig. 1, 2, 4, 5) du manchon 5 dans laquelle les clips de verrouillage 14, 15 sont emboîtés et une position ouverte du manchon 5 (cf. fig. 3) dans laquelle les clips de verrouillage 14, 15 sont dissociés et un accès au passage traversant 6 est offert pour permettre l'introduction du conducteur de courant électrique 2, et inversement. Afin de permettre le pivotement vers la position ouverte du manchon 5, chacune des collerettes 9 est de préférence tronquée du côté de la charnière 13 (cf. fig. 1).

Outre la mise en oeuvre des clips de verrouillage 14, 15, l'invention prévoit la possibilité d'utiliser des moyens de serrage, tels qu'un ou plusieurs colliers de serrage (non représentés) placés chacun de manière réversible dans une des gorges annulaires 7 des zones d'extrémité 51, et pouvant également contribuer au maintien de la position fermée du manchon 5. De tels moyens de serrage ont en outre l'avantage de resserrer encore davantage chacun des orifices d'entrée et de sortie 60, 61 du passage traversant 6 autour du conducteur de courant électrique 2 afin d'éviter tout éventuel mouvement de celui-ci par rapport au manchon 5, de préserver son centrage dans l'ouverture centrale 4 après montage du manchon 5 dans le capteur de courant électrique 3 et d'assurer simultanément le maintien mécanique du capteur de courant électrique 3 sur le manchon 5 et inversement. Si nécessaire, le démontage du manchon 5 est obtenu par retrait des colliers de serrage, traction du manchon 5 dans un sens ou dans l'autre puis séparation des clips de verrouillage 14, 15, de manière à pouvoir pivoter les deux demi-coques 11, 12 dans le sens de leur ouverture. Un tel manchon 5 est avantageusement réutilisable, le cas échéant, après avoir retiré le conducteur de courant électrique 2 du passage traversant 6.

### Possibilités d'application industrielle :

Il ressort clairement de cette description que l'invention permet d'atteindre les buts fixés, à savoir proposer un dispositif de montage 1 d'un conducteur de courant électrique 2 tel qu'un câble électrique, un faisceau de câbles électriques, une barre, une barrette ou autre, dans un capteur de courant électrique 3 tel que notamment une bobine, fermée ou ouvrable, le dispositif de montage 1 permettant de réaliser automatiquement, en une seule étape et de manière précise, le centrage dudit conducteur de courant électrique dans ledit capteur de courant électrique. Sa mise en oeuvre ne nécessite avantageusement aucun outil spécifique ni aucun autre moyen de centrage supplémentaire.

En outre, grâce à la présence des collerettes 9, et au fait que ledit matériau élastique dont est constitué le manchon 5 présente une épaisseur suffisante lui conférant une rigidité permettant audit manchon 5 de supporter à lui seul le poids dudit capteur de courant électrique 3 lorsqu'il est assemblé à ce dernier, indépendamment de tout autre moyen de soutien dudit capteur de courant électrique 3, le dispositif de montage 1 selon l'invention permet de fixer un capteur de courant électrique 3 sur un conducteur de courant électrique 2, en s'affranchissant de l'installation, dans une armoire électrique, de moyens de fixation spécifiques tels qu'un rail ou une platine.

Le dispositif de montage selon l'invention peut par ailleurs être fabriqué en plusieurs tailles différentes et peut être adapté en fonction de celle du conducteur de courant électrique 2 concerné et du capteur de courant électrique 3 selon le calibre de courant à mesurer. D'autre part, sa mise en oeuvre ne nécessitant aucun démontage du conducteur de courant électrique 2, il convient pour toute installation électrique, y compris déjà existante.

Enfin, il présente l'avantage d'être réutilisable puisqu'il est démontable et est donc particulièrement économique tout en contribuant à la préservation de l'environnement.

La présente invention n'est pas limitée à l'exemple de réalisation décrit mais s'étend à toute modification et variante évidentes pour un homme du métier tout en restant dans l'étendue de la protection définie dans les revendications annexées.

## Revendications

1. Dispositif de montage (1) d'au moins un conducteur de courant électrique (2) dans un capteur de courant électrique (3), comportant un manchon (5) pourvu d'un passage traversant (6) s'étendant entre un orifice d'entrée (60) et un orifice de sortie (61) le long d'un axe de symétrie (S) dudit manchon, **caractérisé en ce que** ledit manchon (5) est réalisé en un matériau élastique et comporte deux lèvres souples (9) s'étendant radialement autour de sa périphérie extérieure, respectivement de part et d'autre d'une zone intermédiaire (50), lesdites lèvres souples étant agencées pour adopter une position de montage dans laquelle elles sont déformées et repliées en direction dudit manchon (5) et une position de repos dans laquelle elles sont déployées.

2. Dispositif de montage (1) selon la revendication 1, **caractérisé en ce que** la section externe de ladite zone intermédiaire (50) dudit manchon (5) et/ou ladite section desdits orifices d'entrée (60) et de sortie (61) dudit passage traversant (6) sont de forme circulaire ou polygonale.

3. Dispositif de montage (1) selon la revendication 1, **caractérisé en ce que** ledit manchon (5) comporte deux zones d'extrémités (51) s'étendant respectivement entre ladite zone intermédiaire (50) et l'un desdits orifices d'entrée (60) ou de sortie (61) dudit passage traversant (6), et au niveau desquelles ledit passage traversant (6) comporte des dimensions décroissantes de la zone intermédiaire (50) dudit manchon (5) en direction de chacun des orifices d'entrée (60) ou de sortie (61) dudit passage traversant (6).

4. Dispositif de montage (1) selon la revendication 3, **caractérisé en ce que** ledit passage traversant (6) présente une forme tronconique au niveau de chacune desdites deux zones d'extrémité (51).

5. Dispositif de montage (1) selon la revendication 3, **caractérisé en ce que** la face externe de chacune desdites deux zones d'extrémité (51) comporte une pluralité de gorges annulaires (7) s'étendant autour de leur périphérie délimitant une pluralité d'éléments sécables (8).

6. Dispositif de montage (1) selon la revendication 1, **caractérisé en ce que** ladite zone intermédiaire (50) dudit manchon (5) comporte sur sa périphérie extérieure, autour de chacune de ses extrémités, un évidement annulaire (10) agencé pour permettre le repliement de ladite lèvre souple correspondante en direction dudit manchon (5).

7. Dispositif de montage (1) selon la revendication 1, **caractérisé en ce que** lesdites lèvres souples sont continues et comportent chacune une collerette (9) s'étendant autour de la périphérie extérieure dudit manchon (5).

8. Dispositif de montage (1) selon la revendication 1, **caractérisé en ce que** lesdites lèvres souples sont discontinues et comportent chacune au moins deux pattes ou deux languettes s'étendant autour de la périphérie extérieure dudit manchon (5).

9. Dispositif de montage (1) selon l'une quelconque des revendications précédentes, **caractérisé en ce que** ledit manchon (5) comporte deux demi-coques (11, 12) disposées l'une contre l'autre par rapport à un plan de symétrie passant par ledit axe de symétrie (S) dudit manchon (5), lesdites demi-coques (11, 12) étant reliées entre elles par des moyens d'assemblage.

10. Dispositif de montage (1) selon la revendication 9, **caractérisé en ce que** lesdits moyens d'assemblage comportent une charnière (13) reliant les deux demi-coques (11, 12) entre elles de manière telle qu'elles peuvent pivoter l'une par rapport à l'autre entre une position ouverte dudit manchon (5) dans laquelle un accès audit passage traversant (6) est offert et une position fermée dudit manchon (5) et inversement.

11. Dispositif de montage (1) selon la revendication 10. **caractérisé en ce que** lesdits moyens d'assemblage comportent en outre des moyens de verrouillage dudit manchon (5) en position fermée.

12. Dispositif de montage (1) selon la revendication 11, **caractérisé en ce que** lesdits moyens de verrouillage comportent au moins un clip de verrouillage (14, 15) relié à l'une desdites demi-coques (11, 12) et agencé pour coopérer avec au moins un autre clip de verrouillage (14, 15) de forme complémentaire que comporte l'autre desdites demi-coques (11, 12).

13. Dispositif de montage (1) selon la revendication 1, **caractérisé en ce que** ledit matériau élastique dudit manchon (5) est choisi dans le groupe comprenant un plastique thermoplastique ou un plastique thermodurcissable souple, le silicone, le caoutchouc.

14. Capteur de courant électrique (3) comportant une ouverture centrale (4) agencée pour être traversée par au moins un conducteur de courant électrique (2), et ledit capteur de courant électrique (3) comportant un dispositif de montage (1) selon l'une quelconque des revendications précédentes, monté dans ladite ouverture centrale (4) pour centrer automatiquement ledit au moins un conducteur de courant électrique (2), ledit dispositif de montage (1) comportant un manchon (5) pourvu d'un passage traversant (6) pour recevoir ledit au moins un conducteur de courant électrique (2) et s'étendant entre un orifice d'entrée (60) et un orifice de sortie (61) le long d'un axe de symétrie (S) dudit manchon, **caractérisé en ce que** ledit manchon (5) est réalisé en un matériau élastique et comporte deux lèvres souples (9) s'étendant radialement autour de sa périphérie extérieure, respectivement de part et d'autre d'une zone intermédiaire (50), montée dans ladite ouverture centrale (4), lesdites lèvres souples étant agencées pour adopter une position de montage dans laquelle elles sont déformées et repliées en direction dudit manchon (5) permettant l'introduction dudit manchon (5) dans ladite ouverture centrale (4) et une position de repos dans laquelle elles sont déployées pour reposer autour de ladite ouverture centrale (4) respectivement sur chacune des deux faces (30, 31) opposées dudit capteur de courant électrique (3).

15. Capteur de courant électrique (3) selon la revendication 14, **caractérisé en ce que** ledit matériau élastique dont est constitué ledit manchon (5) présente une épaisseur suffisante lui conférant une rigidité permettant audit manchon (5) de supporter à lui seul le poids dudit capteur de courant électrique (3), indépendamment de tout autre moyen de soutien dudit capteur de courant électrique 3.

## Patentansprüche

1. Vorrichtung (1) zur Montage mindestens eines Stromleiters (2) in einem Stromabnehmer (3), mit einer Hülse (5) mit einem Durchgang (6), der sich zwischen einer Eingangsöffnung (60) und einer Ausgangsöffnung (61) entlang einer Symmetrie-Achse (S) der besagten Hülse erstreckt, **dadurch gekennzeichnet, dass** die besagte Hülse (5) aus einem elastischem Material hergestellt ist und zwei flexible Lippen (9) beträgt, die sich radial um ihren äußeren Umfang beidseitig eines Zwischenbereichs (50) erstrecken, wobei die besagten flexiblen Lippen angeordnet sind, um eine Einbaustellung, in der sie verformt und in Richtung der besagten Hülse (5) gebogen sind, und eine Ruhestellung, in der sie entfaltet sind, einzunehmen.

2. Vorrichtung (1) zur Montage nach Anspruch 1, **dadurch gekennzeichnet, dass** der Außenquerschnitt des besagten Zwischenbereichs (50) der besagten Hülse (5) und/oder der besagte Querschnitt der besagten Eingangsöffnung (60) und Ausgangsöffnung (61) des besagten Durchgangs (6) eine kreisförmige oder polygonale Form aufweisen.

3. Vorrichtung (1) zur Montage nach Anspruch 1, **dadurch gekennzeichnet, dass** die besagte Hülse (5) zwei Endbereiche (51) aufweist, die sich jeweils zwischen dem besagten Zwischenbereich (50) und einer der besagten Eingangsöffnung (60) und Ausgangsöffnung (61) des besagten Durchgangs (6) erstrecken, und bei denen der besagte Durchgang (6) Abmessungen aufweist, die von dem Zwischenbereich (50) der besagten Hülse (5) aus in Richtung jeweils der Eingangsöffnung (60) oder der Ausgangsöffnung (61) des besagten Durchgangs (6) abnehmen.

4. Vorrichtung (1) zur Montage nach Anspruch 3, **dadurch gekennzeichnet, dass** der besagte Durchgang (6) bei jedem der beiden Endbereiche (51) eine Kegelstumpf-Form aufweist.

5. Vorrichtung (1) zur Montage nach Anspruch 3, **dadurch gekennzeichnet, dass** die Außenseite jedes der besagten beiden Endbereiche (51) eine Vielzahl von Ringnuten (7) beträgt, die sich um deren Umfang erstrecken, und eine Vielzahl von trennbaren Elementen (8) begrenzen.

6. Vorrichtung (1) zur Montage nach Anspruch 1, **dadurch gekennzeichnet, dass** der besagte Zwischenbereich (50) der besagten Hülse (5) auf seinem äußeren Umfang um jedes seiner Enden eine ringförmige Vertiefung (10) beträgt, die ausgelegt ist, um das Umbiegen der entsprechenden besagten flexiblen Lippe in Richtung der besagten Hülse (5) zu ermöglichen.

7. Vorrichtung (1) zur Montage nach Anspruch 1, **dadurch gekennzeichnet, dass** die besagten flexiblen Lippen durchgehend sind und jeweils einen Kragen (9) betragen, der sich um den äußeren Umfang der besagten Hülse (5) erstreckt.

8. Vorrichtung (1) zur Montage nach Anspruch 1, **dadurch gekennzeichnet, dass** die besagten flexiblen Lippen unterbrochen sind und jeweils zumindest zwei Laschen oder zwei Zungen betragen, die sich um den äußeren Umfang der besagten Hülse (5) erstrecken.

9. Vorrichtung (1) zur Montage nach einem beliebigen der vorhergehenden Ansprüche, **dadurch gekennzeichnet, dass** die besagte Hülse (5) zwei Halbschalen (11, 12) beträgt, die in Bezug auf eine Symmetrie-Ebene, die durch die besagte Symmetrie-Achse (S) der besagten Hülse (5) geht, aneinander angeordnet sind, wobei die besagten Halbschalen (11, 12) durch Verbindungsmittel miteinander verbunden sind.

10. Vorrichtung (1) zur Montage nach Anspruch 9, **dadurch gekennzeichnet, dass** die besagten Verbindungsmittel ein Scharnier (13) betragen, das die beiden Halbschalen (11, 12) so verbindet, dass sie zueinander schwenken können zwischen einer geöffneten Stellung der besagten Hülse (5), die den Zugang zum besagten Durchgang (6) gewährt, und einer geschlossenen Stellung der besagten Hülse (5) und umgekehrt.

11. Vorrichtung (1) zur Montage nach Anspruch 10, **dadurch gekennzeichnet, dass** die besagten Verbindungsmittel zudem Verriegelungsmittel der besagten Hülse (5) in geschlossener Stellung betragen.

12. Vorrichtung (1) zur Montage nach Anspruch 11, **dadurch gekennzeichnet, dass** die besagten Verriegelungsmittel zumindest einen mit einer der besagten Halbschalen (11, 12) verbundenen Verriegelungs-Clip (14, 15) betragen, der angeordnet ist, um mit zumindest einem anderen Verriegelungs-Clip (14, 15) mit einer entsprechenden Form zusammen zu wirken, der sich auf der anderen der besagten Halbschalen (11, 12) befindet.

13. Vorrichtung (1) zur Montage nach Anspruch 1, **dadurch gekennzeichnet, dass** das besagte elastische Material der besagten Hülse (5) in der Gruppe bestehend aus einem thermoplastischen Kunststoff oder einem flexiblen thermisch erhärtendem Kunststoff, Silikon, Kautschuk, gewählt wird.

14. Stromabnehmer (3) mit einer mittleren Öffnung (4), die angeordnet ist, um von zumindest einem Stromleiter durchquert zu werden, und wobei der besagte Stromabnehmer (3) eine Vorrichtung (1) zur Montage nach einem beliebigen der vorhergehenden Ansprüche beträgt, die in der besagten mittleren Öffnung (4) montiert ist um den besagten zumindest einen Stromleiter (2) automatisch zu zentrieren, wobei die besagte Vorrichtung (1) zur Montage eine Hülse (5) mit einem Durchgang (6) beträgt, der sich zwischen einer Eingangsöffnung (60) und einer Ausgangsöffnung (61) entlang einer Symmetrie-Achse (S) der besagten Hülse erstreckt um den besagten zumindest einen Stromleiter (2) aufzunehmen, **dadurch gekennzeichnet, dass** die besagte Hülse (5) aus einem elastischem Material hergestellt ist und zwei flexible Lippen (9) beträgt, die sich radial um ihren äußeren Umfang beidseitig eines in der besagten mittleren Öffnung (4) eingebauten Zwischenbereichs (50) erstrecken, wobei die besagten flexiblen Lippen angeordnet sind, um eine Einbaustellung einzunehmen, in der sie verformt und in Richtung der besagten Hülse (5) gebogen sind, um das Einsetzen der besagten Muffe (5) in die besagte mittlere Öffnung (4) zu ermöglichen, sowie eine Ruhestellung, in der sie entfaltet sind, um um die besagte mittlere Öffnung (4) herum, jeweils auf einer der beiden entgegen gesetzten Seiten (30, 31) des besagten Stromabnehmers (3), aufzuliegen.

15. Stromabnehmer (3) nach Anspruch 14, **dadurch gekennzeichnet, dass** das besagte elastische Material, aus dem die besagte Muffe (5) hergestellt ist, eine ausreichende Dicke aufweist, dir ihr eine Steifheit verleiht, die der besagten Muffe (5) erlaubt, alleine das Gewicht des besagten Stromabnehmers (3) zu tragen, unabhängig von jeder anderen Trageinrichtung für den besagten Stromabnehmer (3).

## Claims

1. Device (1) for mounting at least one electric current conductor (2) in an electric current sensor (3), including a sleeve (5) provided with a through passage (6) extending between an inlet opening (60) and an outlet opening (61) along a symmetry axis (S) of said sleeve, **characterized in that** said sleeve (5) is made out of an elastic material and includes two flexible lips (9) that extend radially around its external periphery, respectively on each side of an intermediate area (50), said flexible lips being arranged to adopt a mounting position in which they are deformed and folded towards said sleeve (5) and a rest position in which they are unfolded.

2. Mounting device (1) according to claim 1, **characterized in that** the external cross-section of said intermediate area (50) of said sleeve (5) and/or said cross-section of said inlet (60) and outlet (61) openings of said through passage (6) have a circular or polygonal shape.

3. Mounting device (1) according to claim 1, **characterized in that** said sleeve (5) includes two end areas (51) that extend respectively between said intermediate area (50) and one of said inlet (60) or outlet (61) openings of said through passage (6), and at which said through passage (6) has decreasing dimensions from the intermediate area (50) of said sleeve (5) towards each of the inlet (60) or outlet (61) openings of said through passage (6).

4. Mounting device (1) according to claim 3, **characterized in that** said through passage (6) has a tapered shape at each of said two end areas (51).

5. Mounting device (1) according to claim 3, **characterized in that** the external side of each of said two end areas (51) comprises a plurality of annular grooves (7) that extend around their periphery, delimiting a plurality of separable elements (8).

6. Mounting device (1) according to claim 1, **characterized in that** said intermediate area (50) of said sleeve (5) comprises on its external periphery, around each of its ends, an annular recess (10) arranged to allow folding said corresponding flexible lip towards said sleeve (5).

7. Mounting device (1) according to claim 1, **characterized in that** said flexible lips are continuous and comprise each a collar (9) that extends around the external periphery of said sleeve (5).

8. Mounting device (1) according to claim 1, **characterized in that** said flexible lips are discontinuous and comprise each at least two lugs or two tongues that extend around the external periphery of said sleeve (5).

9. Mounting device (1) according to any of the previous claims, **characterized in that** said sleeve (5) comprises two half shells (11, 12) arranged against each other with respect to a symmetry plane passing through said symmetry axis (S) of said sleeve (5), said half shells (11, 12) being attached together by assembly means.

10. Mounting device (1) according to claim 9, **characterized in that** said assembly means comprise a hinge (13) connecting both half shells (11, 12) in such a way that they can pivot with respect to each other between an opened position of said sleeve (5), in which access is granted to said through passage (6), and a closed position of said sleeve (5), and conversely.

11. Mounting device (1) according to claim 10, **characterized in that** said assembly means comprise furthermore locking means of said sleeve (5) in closed position.

12. Mounting device (1) according to claim 11, **characterized in that** said locking means comprise at least one locking clip (14, 15) attached to one of said half shells (11, 12) and arranged to co-operate with at least another locking clip (14, 15) with a complementary shape attached to the other of the two half shells (11, 12).

13. Mounting device (1) according to claim 1, **characterized in that** said elastic material of said sleeve (5) is chosen in the group including a thermoplastic plastic or a flexible thermosetting plastic, silicone, rubber.

14. Electric current sensor (3) comprising a central opening (4) arranged so as to be crossed by at least one electric current conductor (2), and said electric current sensor (3) comprising a mounting device (1) according to any of the previous claims, mounted in said central opening (4) to center automatically said at least one electric current conductor (2), said mounting device (1) including a sleeve (5) provided with a through passage (6) to receive said at least one electric current conductor (2) and extending between an inlet opening (60) and an outlet opening (61) along a symmetry axis (S) of said sleeve, **characterized in that** said sleeve (5) is made out of an elastic material and includes two flexible lips (9) that extend radially around its external periphery, respectively on each side of an intermediate area (50) mounted in said central opening (4), said flexible lips being arranged to adopt a mounting position in which they are deformed and folded towards said sleeve (5), allowing the introduction of said sleeve (5) in said central opening (4), and a rest position in which they are unfolded to rest around said central opening (4) respectively on each of the two opposite sides (30,31) of said electric current sensor (3).

15. Electric current sensor (3) according to claim 14, **characterized in that** said elastic material making up said sleeve (5) has a sufficient thickness giving it a rigidity that allows said sleeve (5) to carry alone the weight of said electric current sensor (3), independently of any other supporting device of said electric current sensor (3).
